# EUROPÄISCHE PATENTSCHRIFT

(11) **EP 1 410 319 B1**
(45) Veröffentlichungstag und Bekanntmachung des Hinweises auf die Patenterteilung: **24.11.2004**
(21) Anmeldenummer: 02754859.3
(22) Anmeldetag: 09.07.2002
(51) Int. Cl.: G06K 19/073, G06K 19/10

(54) **TRAGBARE DATENTRÄGERANORDNUNG MIT SICHERHEITSEINRICHTUNG**
PORTABLE DATA CARRIER ASSEMBLY COMPRISING A SECURITY DEVICE
SUPPORT DE DONNEES PORTABLE DOTE D'UN DISPOSITIF DE SECURITE

(30) Priorität: 12.07.2001 DE 10133855
(43) Veröffentlichungstag der Anmeldung: 21.04.2004
(73) Patentinhaber: Giesecke & Devrient GmbH, 81677 München (DE)
(72) Erfinder: GRASSL, Thomas, 85354 Freising (DE)
(74) Vertreter: Niedermeier, Peter
(86) Internationale Anmeldenummer: PCT/EP2002/007651
(87) Internationale Veröffentlichungsnummer: WO 2003/007231

(56) Entgegenhaltungen:
- EP-A- 0 268 882
- EP-A- 0 565 480
- WO-A-97/22086
- WO-A-98/18102
- DE-A- 19 738 990

## Beschreibung

Die Erfindung betrifft eine Datenträgeranordnung mit Steuereinheit, Datenspeicher, einem der Datenträgeranordnung seine äußere Form leihenden Körper und Mitteln zum Ermöglichen eines Informationsaustauschs zwischen der Steuereinheit und einer externen Zugriffseinheit.

Solche Datenträgeranordnungen sind beispielsweise in Form von kontaktbehafteten oder kontaktlosen Chipkarten, Sicherheitsetiketten, Gepäcketiketten oder FahrzeugschlüsseIn bekannt. Die Steuereinheit, der Datenspeicher und ein Teil der Mittel zum Ermöglichen eines Informationsaustauschs sind hierbei üblicherweise in Form einer elektronischen Schaltung auf einem Chip integriert. Der Informationsaustausch kann beispielsweise über außenliegende Kontakte oder über induktive oder kapazitive Antennen mit einer entsprechenden Transpondereinrichtung erfolgen.

Externe Zugriffseinheiten senden und empfangen Informationen zu bzw. von der Datenträgeranordnung und versorgen diese häufig auch mit Energie. Sie werden trotz bidirektionaler Kommunikationsmöglichkeit meist als Lesegeräte bezeichnet.

In bestimmten Datenträgeranordnungen, wie z. B. Geldkarten, Zugriffskarten oder FahrzeugschlüsseIn zum aktivieren des Fahrbetriebs, zum Deaktivieren von Wegfahrsperren oder zum Betätigen von Schließsystemen, sind sicherheitsrelevante Daten, wie z. B. geheime Schlüsseldaten abgespeichert. Solche sicherheitsrelevanten Daten sind, solange die elektronische Schaltungsanordnung des Chips sich nicht im Betriebszustand befindet, aufgrund von verschlüsseltem Speichern nicht ausspähbar. Ein Angriff auf die in einem Chip gespeicherten sicherheitsrelevanten Daten erfordert folglich, daß die elektronische Schaltungsanordnung des Chips sich im Betriebszustand befindet und die sicherheitsrelevanten Daten entschlüsselt gespeichert sind.

Angriffe auf geheime Daten in einer Datenträgeranordnung können über die Außenkontakte einer kontaktbehafteten Datenträgeranordnung oder über die Funkverbindung einer kontaktlosen Datenträgeranordnung erfolgen. Es gibt jedoch etliche, hier nicht näher erläuterte Maßnahmen, um zu verhindern, daß solche Angriffe den Zugang zu geheimen Schlüsseldaten oder anderen sicherheitsrelevanten Daten ermöglichen. Eine weitere Möglichkeit zum Ausspähen von Daten ist ein Angriff auf den Chip, beispielsweise, um mit fokussierten Ionenstrahlen oder mit Hilfe von der Elektronenmikroskopie den Ladungszustand von Speicherzellen oder den Datenfluss auf Datenbussen zu ermitteln. Ein solcher Angriff auf den Chip erfordert üblicherweise das Entfernen des Chips oder zumindest eines Chipmoduls mit Chip und Kontakten oder Transponderantenne aus der Karte. Hierzu wird die Karte meist stark beschädigt oder das Kartenmaterial chemisch aufgelöst.

Aus der deutschen Offenlegungsschrift DE 197 38 990 A1 ist eine Chipkarte mit einer Sicherheitseinrichtung bekannt, die einen Oszillator zum Senden eines Sicherheitssignales enthält. Das vom Oszillator ausgesendete Signal wird durch eine Kapazitätsanordnung, welche Teil des Moduls ist, angeregt und erzeugt einen Wert, der für den abgetasteten Kapazitätswert charakteristisch ist. Dieses Signal wird mit einem Detektionsmittel detektiert, durch ein Auswertemittel ausgewertet und die Funktion der Karte wird freigegeben, wenn der abgetastete Kapazitätswert mit dem chipspezifischen Kapazitätswert übereinstimmt. Die obengenannte Offenlegungsschrift bildet die Grundlage für den Oberbegriff des Anspruchs 1.

Aufgabe der Erfindung ist es, eine Datenträgeranordnung der eingangs genannten Art anzugeben, die Angriffe auf den im Betriebszustand befindlichen Chip dieser Datenträgeranordnung erschwert.

Diese Aufgabe wird gelöst durch eine tragbare Datenträgeranordnung mit einer Steuereinheit, mit einem der Datenträgeranordnung seine Form leihenden Körper, mit einem in einem Chip integrierten Datenspeicher, in dem sicherheitsrelevante Daten speicherbar sind, und mit einem Mittel zum Ermöglichen eines Informationsaustauschs zwischen der Steuereinheit und einer externen Zugriffseinheit. Eine solche Datenträgeranordnung hat erfindungsgemäß eine Sicherheitseinrichtung zum Abgeben eines Sicherheitssignals und ein im Körper integriertes, mit der Sicherheitseinrichtung nicht elektrisch verbundenes Beeinflussungsmittel zum Beeinflussen des Sicherheitssignals. Außerdem hat die Sicherheitseinrichtung ein Detektionsmittel zum Detektieren des vom Beeinflussungsmittel beeinflußten Sicherheitssignals. Ein Auswertemittel ist vorgesehen, zum Auswerten des detektierten, beeinflußten Sicherheitssignals. Ein Sperrmittel sperrt einen sicherheitskritischen Betriebszustand der Datenträgeranordnung, falls das Auswertemittel kein in erwarteter Weise beeinflußtes Sicherheitssignal erkennt.

Das Sperren eines sicherheitskritischen Betriebszustands der Datenträgeranordnung kann beispielsweise das Schließen eines aktiven Programms, das Verhindern eines Programmstarts oder das Löschen eines Speichers sein, der sicherheitsrelevante Daten enthält.

Die Steuereinheit einer erfindungsgemäßen Datenträgeranordnung kann eine Logikschaltung sein zum Realisieren vorgegebener Abläufe. Ebenso kann es sich auch um einen Mikrocomputer oder Mikrocontroller mit entsprechender Steuersoftware handeln. Der Körper der Datenträgeranordnung kann beispielsweise die Form einer Chipkarte haben oder eines Schlüssels. Es kommt aber auch jede andere, vorzugsweise bequem zu tragende Form in Frage, wie z. B. ein am Körper tragbares Schmuckstück, ein Schlüsselanhänger oder ein Sicherheitsetikett. Geeignete, am Körper tragbare Schmuckstücke könnten z. B. in Form eines Rings, einer Armbanduhr, eines Anhängers oder einer Brosche ausgestaltet sein.

Als Mittel zum Ermöglichen eines Informationsaustauschs zwischen der Steuereinheit und einer externen Zugriffseinheit kann z.B. eine Signalein-/ausgabeeinheit mit einer Kontaktflächenanordnung vorgesehen sein, aber auch eine Signalein-/ausgabeeinheit mit kontaktloser Koppeleinrichtung, wie z. B. einer induktiven oder kapazitiven Koppelanordnung oder einer Funkantenne.

Gattungsgemäße Datenträgeranordnungen in Form einer Chipkarte sind beispielsweise aus Wolfgang Rankl/Wolfgang Effing, Handbuch der Chipkarten, 3. Auflage, Carl Hansa Verlag, 1999, bekannt. Dort werden insbesondere Speicherkarten, Mikroprozessorkarten und kontaktlose Chipkarten, Signalein-/ausgabeeinheiten mit Kontakten und Signalein-/ausgabeeinheiten für kontaktlose Karten prinzipiell beschrieben.

Gattungsgemäße kontaktlose Datenträgeranordnungen verschiedener Bauformen werden in Klaus Finkenzeller, RFID-Handbuch, 2. Auflage, Carl Hansa Verlag, 2000, detailliert erläutert.

Die erfindungsgemäße Sicherheitseinrichtung zum Senden eines Sicherheitssignals und das entsprechende Beeinflussungsmittel zum Beeinflussen des Sicherheitssignals sind stark voneinander abhängig und aufeinander abgestimmt. Das Besondere an der Sicherheitseinrichtung und dem Beeinflussungsmittel ist, daß beim Betrieb der Steuereinheit einer Datenträgeranordnung überprüft werden kann, ob der Kartenkörper oder zumindest das Beeinflussungsmittel sich in der Nähe oder gar in einer bestimmten räumlichen Konstellation zu der Sicherheitseinrichtung und somit dem Datenspeicher befindet. Die Sendeleistung der Sicherheitseinrichtung kann extrem gering sein, da das Beeinflussungsmittel sehr eng benachbart zu der Sicherheitseinrichtung bzw. deren Signal-Koppeleinrichtung angeordnet sein kann.

In einer Weiterbildung einer erfindungsgemäßen Datenträgeranordnung ist als Beeinflussungsmittel ein Transponder vorgesehen. Insbesondere aus dem oben erwähnten RFID-Handbuch ist eine Vielzahl verschiedener Transponder in sog. RFID-Systemen (nach dem englisch sprachigen Begriff "Radio Frequency IDentification") bekannt. Die für solche RFID-Systeme geltenden technischen Zusammenhänge zwischen Transponder und Lesegerät, wie Koppelung, Energieübertragung, Signalübertragung, Signalauswertung usw. sind hierbei auch auf Transponder gemäß der vorliegenden Erfindung anwendbar. Ein großer Unterschied zwischen bekannten Transpondern und einem Transponder gemäß der vorliegenden Erfindung ist, daß ein Transponder gemäß dem Stande der Technik eine Datenträgeranordnung ist, die mit einem stationären Lesegerät kommuniziert. Ein solcher Transponder gemäß kann, wie vorstehend erwähnt eine gattungsgemäße Datenträgeranordnung sein.

Ein Transponder einer erfindungsgemäßen Datenträgeranordnung ist nicht zur Kommunikation mit einem außerhalb des Körpers der Datenträgeranordnung angeordneten Lesegerät vorgesehen, sondern zum Zusammenwirken mit einer innerhalb der Datenträgeranordnung angeordneten Sicherheitseinrichtung, die bezüglich des Transponders zumindest teilweise die Funktionalität eines Lesegerätes hat. Ein Transponder in einer erfindungsgemäßen Datenträgeranordnung bildet somit zusammen mit einer Sicherheitseinrichtung ein datenträgeranordnungsinternes RFID-System. Da ein solches System zum Schutz eines Chips vor unberechtigten Angriffen dienen soll, ist die genannte Sicherheitseinrichtung vorzugsweise zumindest teilweise in dem zu schützenden Chip integriert.

Zu den Besonderheiten eines erfindungsgemäßen, datenträgeranordnungsinternen RFID-Systems zählt, daß aufgrund der kurzen Entfernung innerhalb des Datenträgeranordnungskörpers die Sendeleistung sehr gering sein kann und auch Koppelantennen oder Spulen sehr klein sein dürfen. Andererseits sollte die Sicherheitseinrichtung vorzugsweise nicht allzu kompliziert aufgebaut sein und der Energieverbrauch des RFID-Systems sollte vorzugsweise gering sein. Auch sollte ein Transponder sehr klein und möglichst preiswert sein. Unter Berücksichtigung dieser Vorgaben kann eine erfindungsgemäße Datenträgeranordnung bezüglich Ihrer Sicherheitseinrichtung und Ihrem Beeinflussungsmittel weitgehend alle in der einschlägigen Literatur beschriebenen Techniken verwenden. Beispielsweise kann ein so genannter 1-Bit-Transponder verwendet werden, der nur die Information "Transponder anwesend" bzw. "Transponder nicht anwesend" übertragen kann.

Zusätzliche Informationen bezüglich der räumlichen Anordnung des Transponders relativ zur Sicherheitseinrichtung können in diesem Falle aus koppelungsabhängigen Informationsbestandteilen einer durch die Detektoreinrichtung vom Transponder empfangenen Sicherheitsinformation hergeleitet werden. Außerdem kann das datenträgeranordnungsinterne RFID-System nach einem so genannten Radiofrequenz-Verfahren arbeiten, bei dem als Transponder ein Schwingkreis verwendet wird und die Signalfrequenz eines von der Sicherheitseinrichtung abgegebenen Sicherheitssignals und die Resonanzfrequenz eines solchen Schwingkreises aufeinander abgestimmt werden. Hierbei wird vorzugsweise die Signalfrequenz des Sicherheitssignals an die tatsächliche Resonanzfrequeriz des Schwingkreises angepaßt, so daß der Transponder ohne Abgleich als Massenprodukt gefertigt werden kann. Falls eine fest vorgegebene Signalfrequenz verwendet wird, kann die für die Sicherheitseinrichtung wirksame Resonanzfrequenz einer solchen Transponderanordnung trotzdem durch eine in der Sicherheitseinrichtung integrierte, veränderbare Kapazität abgeglichen werden. Hierzu muß eine solche veränderbare Kapazität als Teil eines den Signalausgang der Sicherheitseinrichtung belastenden, unter Verwendung einer Transponderanordnung realisierten Resonanzkreises vorgesehen sein.

Auch kann ein Beeinflussungsmittel einer erfindungsgemäßen Datenträgeranordnung aus einem Dipol mit nichtlinearem aktivem Element bestehen, um in bekannter Weise Harmonische eines von der Sicherheitseinrichtung abgegebenen Mikrowellensignals zu bilden, die von einem Auswertemittel ausgewertet werden können. Darüber hinaus kann das Beeinflussungsmittel die Lastmodulation eines von einer Sicherheitseinrichtung abgegebenen Sicherheitssignals bewirken, wie insbesondere ohmsche Lastmodulation oder kapazitive Lastmodulation. Außerdem können als Beeinflussungsmittel eine Antenne und eine elektronische Schaltung vorgesehen sein, wobei die Schaltungsanordnung den Lastwiderstand der Antenne ändert, um den Rückstrahlquerschnitt zu modulieren (engl.: modulated backscatter). Eine Sicherheitseinrichtung sendet in diesem Fall ein Signal und detektiert das von dem Beeinflussungsmittel zurückgesendete, modulierte Signal. Wenn die Modulation in geeigneter Weise signifikant für das Vorhandensein des intakten Beeinflussungsmittels ist, kann eine Auswerteeinheit das Fehlen eines solchen Beeinflussungsmittels erkennen. Falls die Signalamplitude des reflektierten Sicherheitssignals, evtl. zusätzlich abhängig von unterschiedlichen Signalamplituden des von der Sicherheitseinrichtung abgegebenen Sicherheitssignals, als weiteres Kriterium für das Vorhandensein des Beeinflussungsmittels verwendet wird, erkennt ein Auswertemittel einer solchen Datenträgeranordnung mit sehr hoher Sicherheit Manipulationen an der Datenträgeranordnung.

Eine einfache Ausgestaltungsform eines passiven Beeinflussungsmittels kann beispielsweise ein Bauelement mit komplexer Impedanz sein, also eine Kapazität oder eine Induktivität als Teil eines Resonanzkreises oder aber ein eigenständiger Resonanzkreis. Eine solche Impedanz oder ein solcher Resonanzkreis können beispielsweise per induktiver oder kapazitiver Koppelung als Lastimpedanz eines Hochfrequenzsignalgenerators der Sicherheitseinrichtung vorgesehen sein. Eine relative Verschiebung induktiver Koppelspulen der Sicherheitseinrichtung und des Beeinflussungsmittels oder eine relative Verschiebung von als Kondensatorplatten wirkenden elektrisch leitfähigen Flächen der Sicherheitseinrichtung und des Beeinflussungsmittels führen zu einer Änderung des Koppelfaktors, zu einer Änderung der Güte eines solchen Schwingkreises und zu einer Änderung der Resonanzfrequenz.

Die Signalpegelhöhe eines durch einen Resonanzkreis belasteten Hochfrequenzgenerators hängt in nicht linearer Weise von der Ausgangsfrequenz des Hochfrequenzgenerators bzw. von der Ablage dieser Ausgangsfrequenz des Hochfrequenzgenerators von der Resonanzfrequenz des Resonanzkreises ab. Wenn die Sicherheitseinrichtung Ausgangssignale mit unterschiedlichen Frequenzen im Bereich der Resonanzfrequenz des Resonanzkreises abgibt, wird eine Detektoreinrichtung bei vorschriftsmäßiger Konstellation von Sicherheitseinrichtung und Beeinflussungsmittel innerhalb bestimmter Grenzen einen vorhersehbaren Signalpegel in Abhängigkeit von der Signalfrequenz ermitteln. Wenn z. B. zwei Sicherheitssignalfrequenzen ausgegeben werden, die beide nach der selben Seite hin von der Resonanzfrequenz abweichen, wird die Differenz der detektierbaren Ausgangssignalpegel beider Frequenzen weitgehend gleich sein. Bei enger Koppelung und ausreichender Güte des Resonanzkreises machen sich äußere Einflußgrößen nicht sehr stark bemerkbar.

Wenn eine Sicherheitseinrichtung gemäß einer anderen Ausgestaltungsform der Erfindung zeitlich zyklisch zwischen zwei Grenzfrequenzen kontinuierlich oder stufenweise die Frequenz des Sicherheitssignals ändert und seine Amplitude detektiert, wird sich aufgrund des Überschreitens der Resonanzfrequenz des Resonanzkreises weitgehend bei der selben Ausgangsfrequenz die Amplitudenänderungsrichtung des Sicherheitssignals ändern. Die entsprechende Frequenz des Sicherheitssignals oder die relative Zeitspanne zwischen dem Ausgeben einer der Grenzfrequenzen und dieser entsprechenden Frequenz können hierbei ein Maß für ein in erwarteter Weise beeinflußtes Sicherheitssignal sein.

Wenn in einem der beiden vorstehend beispielhaft beschriebenen Fälle das Beeinflussungsmittel entfernt wird, durch ein anderes, in seiner Impedanz oder seinen Koppelverhalten abweichendes Beeinflussungsmittel ersetzt wird oder wenn der Abstand zwischen den Koppelelementen des Beeinflussungsmittels und der Sicherheitseinrichtung sich in irgendeiner Richtung ändert, führt dies zu einer signifikanten Änderung der Resonanzfrequenz und/oder der Güte des Resonanzkreises und/oder des Koppelfaktors. Ein Auswertemittel kann demzufolge nicht das in erwarteter Weise beeinflußtes Sicherheitssignal erkennen.

Vorzugsweise ist die Sicherheitseinrichtung beispielsweise nach Beendigung der Montage der Datenträgeranordnung abgleichbar. Dadurch können physikalische Besonderheiten des spezifischen Beeinflussungsmittels und evtl. Besonderheiten der relativen Lage von Sicherheitseinrichtung und Beeinflussungsmittel ausgeglichen werden. So kann z. B. die Signalfrequenz eines Sicherheitssignals in Abhängigkeit von der tatsächlichen Resonanzfrequenz bzw. des tatsächlichen frequenzabhängigen Verhaltens des Beeinflussungsmittels abgeglichen werden oder die Resonanzfrequenz kann durch für den Resonanzkreis wirksame Kapazitäten abgeglichen werden. Dadurch können für die Unversehrtheit der Sicherheitseinrichtung, des Beeinflussungsmittels und des dazwischen befindlichen Teils des Kartenkörpers signifikante Merkmale des detektierten Sicherheitssignals als Auswertekriterium eingestellt werden.

In einer bevorzugten Ausgestaltungsform einer erfindungsgemäßen Datenträgeranordnung prüft das Auswertemittel zwei oder mehr Informationen, die von der Anwesenheit eines erforderlichen Beeinflussungsmittels abhängig sind. Dadurch können die Grenzwerte der einzelnen Informationsarten, also die zulässigen Abweichungen vom Idealwert, mit größerer Toleranz gewählt werden, oder die Sicherheit kann bei gleicher Toleranz dieser Grenzwerte erhöht werden. Vorzugsweise ist eine der Informationsarten abhängig von der Signalamplitude des detektierten Sicherheitssignals, so daß auf einfache Weise neben dem absoluten Vorhandensein des Beeinflussungsmittels auch die relative Anordnung vom Beeinflussungsmittel zur Sicherheitseinrichtung und somit zum Chip mit den sicherheitsrelevanten Daten als Auswertekriterium berücksichtigt werden kann.

Wenn die zulässigen Grenzwerte des Auswertemittels für eine solche von der Signalamplitude abhängige Information nach Montage der Datenträgeranordnung festlegbar sind, können diese Grenzwerte eng gewählt werden und eine Lageänderung des Beeinflussungsmittels relativ zur Sicherheitseinrichtung oder ein simuliertes beeinflußtes Sicherheitssignal führen mit großer Wahrscheinlichkeit nicht zu einem in erwarteter Weise beeinflußten detektierten Sicherheitssignal in der Sicherheitseinrichtung.

Eine andere mögliche Kombination aus Sicherheitseinrichtung und einfachem, passivem Beeinflussungsmittel sieht als Beeinflussungsmittel ein Laufzeitglied, wie z. B. eine Streifenleitungsanordnung vor. Wenn eine mit dem Chip zusammenhängende Sicherheitseinrichtung ein gepulstes Signal sehr hoher Frequenz kapazitiv in ein solches Laufzeitglied einkoppelt und das Detektormittel dieses, von dem Laufzeitglied phasenverschobene Signal kapazitiv auskoppelt, ist die Phasenverschiebung zwischen eingekoppeltem Sicherheitssignal und ausgekoppeltem Sicherheitssignal ein signifikantes Merkmal für das Vorhandensein des unzerstörten Beeinflussungsmittels. Das gepulste Sicherheitssignal kann hierbei pulsweitenmoduliert, pulscodemoduliert oder anderweitig codiert sein. Wesentlich ist nur, daß die durch das Beeinflussungsmittel bedingte Phasenverschiebung durch ein Erfassungsmittel erfassbar ist. Liegt bei einer solchen Datenträgeranordnung nach einem Manipulationsversuch die Phasenlage zwischen gesendetem Sicherheitssignal und detektiertem, d. h. empfangenem Sicherheitssignal nicht innerhalb eines erwarteten Bereiches, kann ein Auswertemittel kein in erwarteter Weise beeinflusstes Sicherheitssignal erkennen.

Falls eine kapazitive Kopplung des Sicherheitssignals vorgesehen ist, erfolgt diese vorzugsweise zwischen einer elektrisch leitenden Fläche der Sicherheitseinrichtung auf dem Chip oder auf einem mit dem Chip fest verbundenen Modul und einer elektrisch leitenden Fläche des Beeinflussungsmittels im Körper der Datenträgeranordnung. Dadurch beeinflußt die relative Lage von Beeinflussungsmittel und Chip unmittelbar die Koppelkapazität. Falls das Beeinflussungsmittel Teil eines Resonanzkreises ist oder ein Laufzeitglied ist, beeinflußt die Koppelkapazität unmittelbar das frequenzabhängige Verhalten des Beeinflussungsmittels. Darüber hinaus beeinflusst die Koppelkapazität in gewissen Grenzen auch die Amplitude des übertragenen Sicherheitssignals.

Ein ähnlicher Zusammenhang, wie für die kapazitive Kopplung, gilt auch für eine induktive Kopplung, falls eine Induktivität der Sicherheitseinrichtung infolge räumlicher Zuordnung mit einer Induktivität des Beeinflussungsmittels einen induktiven Übertrager bildet. Auch hier hängen der Koppelfaktor, die Güte und die für die Sicherheitseinrichtung wirksame resultierende Induktivität signifikant von der relativen Lage der beiden Induktivitäten zueinander ab.

Insbesondere im Falle höher Sicherheitsanforderungen kann als Beeinflussungsmittel ein Transponder mit aktiven Elementen und einer Energiekoppelvorrichtung zum Übertragen von elektrischer Energie von dem Chip zum Beeinflussungsmittel verwendet werden. In einem solchen Fall kann als einfachste Form eines Sicherheitssignals ein Signal mit alternierender Amplitude, wie z. B. ein Taktsignal vorgesehen sein, daß die Energieversorgung eines solchen Transponders gewährleistet. Eine Ausgestaltungsform eines solchen Transponders kann beispielsweise eine gespeicherte Information abgeben. Diese Information kann z. B. durch Lastmodulation des Sicherheitssignals oder durch Abgabe eines Sendesignals zum Detektionsmittel der Sicherheitseinrichtung übermittelt werden. Im Falle einer Lastmodulation wird hierbei das Sicherheitssignal von dem Transponder unmittelbar beeinflußt. Im Falle des eigenständigen Sendens einer gespeicherten Information besteht diese Beeinflussung im Umsetzen des Sicherheitssignals in eine Versorgungsspannung und im Abgeben eines eigenständigen, aus dieser Versorgungsspannung gebildeten Informationssignals.

Neben dem Vorhandensein der vom Transponder abgegebenen Information kann beispielsweise eine für jeden Transponder zufällige Verzögerungszeit zwischen dem Einsetzen des Sicherheitssignals und dem Abgeben der Information als Auswertekriterium des Auswertemittels vorgesehen sein.

In einer besonders günstigen Ausgestaltung einer erfindungsgemäßen Datenträgeranordnung ist das Auswertekriterium des Auswertemittels auf physikalische Eigenschaften, wie eine Resonanzfrequenz oder eine Verzögerungszeit des Beeinflussungsmittels abgleichbar. Dadurch kann ein in betrügerischer Absicht simuliertes Beeinflussungsmittel nicht eine erwartete Beeinflussung des Sicherheitssignals bewirken.

Eine besonders sichere Ausgestaltungsform einer erfindungsgemäßen Datenträgeranordnung sieht als Beeinflussungsmittel einen Transponder vor, der eine in einem Sicherheitssignal enthaltene digitale Information in nur von der Sicherheitseinrichtung vorhersehbarer Weise bearbeitet und das Ergebnis dieser Bearbeitung zur Sicherheitseinrichtung übermittelt. Die Sicherheitseinrichtung kann durch Senden zufälliger Bitfolgen mit Sicherheit anhand des detektierten Ergebnisses feststellen, ob das Beeinflussungsmittel noch im Originalzustand vorhanden ist. Wenn in einem solchen Fall zusätzlich eine Analogwertkomponente als Auswertekriterium verwendet wird, kann auch der Originalzustand der Datenträgeranordnung geprüft werden. Neben einer Überprüfung der Amplitude oder des Effektivwertes eines vom Beeinflussungsmittel empfangenen detektierten Signales kann beispielsweise auch eine Verzögerungszeit eine solche analoge Komponente sein. So kann beispielsweise eine kapazitive Koppelung zwischen Sicherheitseinrichtung und Beeinflussungsmittel vorgesehen sein, wobei die räumliche Anordnung des Beeinflussungsmittels zur Sicherheitseinrichtung die Höhe der Kapazität festlegt. Eine solche Kapazität kann beispielsweise durch berührungslos überlappende metallische Flächen des Beeinflussungsmittels und eines die Sicherheitseinrichtung enthaltenden Chipmoduls gemeinsam mit dem sich zwischen diesen Flächen befindlichen Körpermaterial gebildet sein. Hierbei bestimmen neben der Flächenausdehnung der einzelnen metallischen Flächen auch deren Überlappungsgrad, der Abstand zwischen den Flächen und die die Elektrizitätskonstante des dazwischen befindlichen Körpermaterials Kapazität. Jede räumliche Änderung der Lage dieser Flächen zueinander führt somit zu einer Kapazitätsänderung. Wenn ein derart festgelegter Kapazitätswert beispielsweise als bestimmende Größe einer Verzögerungszeit zwischen einer Aktion der Sicherheitseinrichtung und einer Reaktion des Beeinflussungsmittels verwendet wird und die Grenzwerte dieser Verzögerungszeit nach der endgültigen Montage der Datenträgeranordnung ermittelt werden und in dem Auswertemittel eingestellt werden, führt eine Manipulation am Chip, am Körpermaterial oder an dem Beeinflussungsmittel mit hoher Wahrscheinlichkeit zu einer von Auswertemittel erkennbaren unzulässigen Abweichung des vom Detektionsmittel detektierten Signals. Auch bei induktiver Koppelung kann ein ähnlicher Effekt erzielt werden.

Zur besseren Signalkopplung zwischen der Sicherheitseinrichtung und dem Beeinflussungsmittel oder auch aus Gründen der Energieersparnis, ist es empfehlenswert, das Beeinflussungsmittel unmittelbar benachbart zum Chip im Körper der Datenträgeranordnung anzuordnen.

Nachstehend wird die Erfindung unter Bezugnahme auf die Figuren der Zeichnung näher erläutert.

Es zeigen:
- Fig. 1: in schematischer Blockdarstellung ein erstes spezielles Ausführungsbeispiel einer erfindungsgemäßen Datenträgeranordnung;
- Fig. 2: in schematischer Blockdarstellung den von dem Ausführungsbeispiel nach Fig. 1 abweichenden Teil eines zweiten speziellen Ausführungsbeispiels einer erfindungsgemäßen Datenträgeranordnung; und
- Fig. 3A, B und C: in schematischer Schnittdarstellung einen Teil einer möglichen Realisierungsform einer Datenträgeranordnung gemäß dem Ausführungsbeispiel aus Fig. 2.

In den Figuren bezeichnen gleiche Bezugszeichen die selben Funktionseinheiten und Bezugszeichen mit gleichen Bezugsziffern Ausgestaltungsformen der Funktionseinheiten mit entsprechenden Bezugszeichen.

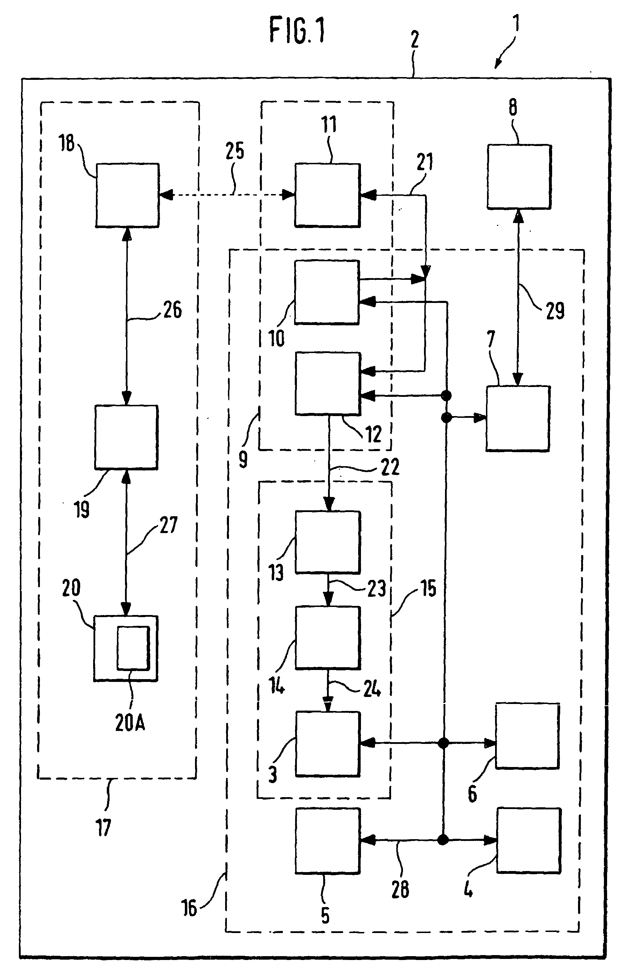

Fig. 1 zeigt eine Datenträgeranordnung 1 mit einem der Datenträgeranordnung seine äußere Form leihenden Körper 2. Diese Datenträgeranordnung 1 enthält in bekannter Weise einen Chip 16 und eine Koppelvorrichtung 8 zum Ermöglichen eines Informationsaustauschs, beispielsweise ein Kontaktfeld oder eine Antenne. Der Chip des dargestellten Ausführungsbeispiels hat einen Mikroprozessor 15, der eine Steuereinheit 3 zum Steuern der Funktionsabläufe der Datenträgeranordnung realisiert. Die Steuereinheit 3 ist über einen Steuer- und Datenbus 28 mit einem durch ein ROM realisierten Festwertdatenspeicher 4, einem durch ein EEPROM realisierten nichtflüchtigen Speicher 5 und einem durch ein RAM realisierten Arbeitsspeicher 6 verbunden. Der Daten- und Steuerbus 28 ist außerdem mit einer Ein-/Ausgabeeinheit 7 verbunden, die über die Koppelvorrichtung 8 einen Informationsaustausch mit einem externen, in der Fig. nicht dargestellten Schreib-/Lesegerät ermöglicht. Die Ein-/Ausgabeeinheit 7 kann hierbei abhängig von der Art des Informationsaustauschs und gegebenenfalls des Energieaustauschs über die Koppelvorrichtung beispielsweise eine Spannungsstabilisierungseinrichtung, eine Taktgenerierungseinrichtung und eine Treiberanordnung enthalten. Im Falle eines kontaktlosen Informationsaustauschs können auch ein Modem und eine Sende-/Empfangseinrichtung in der Ein-/Ausgabeeinheit 7 vorgesehen sein. Die Ein-/ Ausgabeeinheit 7 ist zum Austauschen von Information und Versorgungsenergie über eine Verbindung 29 mit der Koppelvorrichtung 8 verbunden.

Erfindungsgemäß ist eine Sicherheitseinrichtung 9 vorgesehen mit einer Antenne 11 als Koppeleinheit der Sicherheitseinrichtung 9, einer Sendeeinheit 10 zum Senden eines Sicherheitssignals über die Antenne 11 und einem Empfänger/Demodulator als Detektionsmittel 12. Die Antenne 11 ist hierbei über eine Sicherheitssignalleitung 21 mit der Sendeeinheit 10 und dem Detektionsmittel 12 verbunden. Die Sendeeinheit 10 und der Empfäger/Demodulator 12 sind im dargestellten Ausführungsbeipiel im Chip 16 integriert und werden von der Steuereinheit 3 zum Steuern der Funktionsabläufe der Datenträgeranordnung 1 gesteuert. Das Detektionsmittel 12 ist über eine Verbindung 22 zum Übermitteln des detektierten, beeinflußten Sicherheitssignals mit einem durch den Mikroprozessor 15 realisierten Auswertemittel 13 verbunden. Dieses Auswertemittel 13 ist über eine Verbindung 23 zum Übermitteln des Auswerteergebnisses mit einem Sperrmittel 14 verbunden, das ebenfalls durch den Mikroprozessor 15 realisiert ist. Das Sperrmittel 14 übermittelt eine Sperrinformation über eine Verbindung 24 an die Steuereinheit 3 der Datenträgeranordnung. Die Verbindungen 23 und 24 sind in erster Linie zur Verdeutlichung des Informationsflusses zwischen den Funktionsblöcken 13, 14 und 3 dargestellt. Der tatsächliche Informationsfluss findet innerhalb des Mikroprozessors 15 in üblicher Weise statt.

In dem Körper 2 ist auch ein Beeinflussungsmittel 17 vorgesehen mit einer Antenne 18 als Koppeleinheit des Beeinflussungsmittels 17. Die Antenne 18 ist über eine Sicherheitssignalleitung 26 mit einer Hochfrequenzeinheit 19 verbunden, die ihrerseits über eine Informationsleitung 27 mit einer Signalbeeinflussungssteuerung 20 verbunden ist. Im dargestellten Ausführungsbeispiel der Fig. 1 hat die Signalbeeinflussungssteuerung 20 außerdem einen Verzögerungszeitgeber 20a, dessen Zeitkonstante in nicht dargestellter Weise durch eine Kapazität bestimmt wird, die von der Anordnung des Beeinflussungsmittels 17 im Körper 2 abhängt. Die Signalbeeinflussungssteuerung 20 tauscht über die Informationsleitung 27 mit der Hochfrequenzeinheit 19 Informationen aus.

Die Hochfrequenzeinheit 19 des Beeinflussungsmittels 17 enthält in für RFID-Transponder bekannter Weise eine Spannungsregeleinrichtung zum Erzeugen einer Versorgungsspannung für das Beeinflussungsmittel 17 aus einem über eine nichtgalvanische Kopplung 25 empfangenen Sicherheitssignal. Die Hochfrequenzschnittstelle 19 enthält außerdem eine Modulatoreinheit zum Beeinflussen eines Empfangenen Sicherheitssignals und eine Empfangseinheit zum Empfangen und Demodulieren des Sicherheitssignals.

Die Signalbeeinflussungssteuerung 20 legt die Art der Beeinflussung eines von der Sicherheitseinrichtung 9 empfangenen Sicherheitssignals fest. Dies könnte in einfachen Ausführungsformen einer erfindungsgemäßen Datenträgeranordnung durch das Abgeben eines vorgegebenen gespeicherten Informationsinhaltes realisiert werden, wobei auf eine Empfangseinheit der Hochfrequenzeinheit 19 verzichtet werden könnte. Im vorliegenden Ausführungsbeispiel wird jedoch eine von der Sicherheitseinrichtung 9 empfangene Information nach einem vorgegebenen Algorithmus bearbeitet und das Bearbeitungsergebnis wird an die Hochfrequenzschnittstelle 19 übermittelt, die ihrerseits durch Lastmodulation den Rückstrahlquerschnitt der Antenne 18 moduliert.

Der Körper 2 im dargestellten Ausführungsbeispiel entspricht dem Körper einer Chipkarte. Das Masken-ROM 4 dient zum Speichern der Standardbefehle des Betriebssystems des Chips dieser Chipkarte. Der nichtflüchtige Speicherbereich EEPROM 5 dient zum Speichern spezifischer Betriebssystembefehle und zum Speichern zusätzlichen Programmcodes. Außerdem dient der EEPROM-Speicher 5 als Datenspeicher, unter anderem zum Speichern sicherheitsrelevanter Daten. Die sicherheitsrelevanten Daten sind hierbei mit Hilfe verdeckter Adressierung gesichert und können somit nicht ausgespäht werden.

Der Arbeitsspeicher 6 ist ein flüchtiger Speicher und alle in diesem Speicher gespeicherten Informationen gehen bei Abschalten der Versorgungsspannung verloren. Vorzugsweise wird ein Speicher mit selbstlöschenden Speicherzellen verwendet, die den Speicherinhalt bei Wegfall der Versorgungsspannung unmittelbar löschen, indem sie die Speicherkapazitäten der einzelnen Speicherzellen gegen ein festes Potential schalten. Wenn die Koppelvorrichtung 8 ein Kontaktfeld einer kontaktbehafteten Chipkarte ist, enthält die Ein-/Ausgabeeinheit 7 ein Register mit Treibern, um Daten bitweise zu übertragen.

Im Betriebsfall, also beim Einlegen einer solchen Chipkarte in ein Lesegerät, wird der Chip 16 über die Koppelvorrichtung 8 und die Verbindung 29 mit Energie versorgt und die Steuereinheit 3 veranlaßt das Übernehmen erforderlicher Daten einschließlich sicherheitsrelevanter Daten aus dem nichtflüchtigen Datenspeicher EEPROM 5 in den Arbeitsspeicher RAM 6. Vor dem Übernehmen sicherheitsrelevanter Daten aus dem EEPROM in den Arbeitsspeicher 6 veranlaßt die Steuereinheit 3 die Sendeeinheit 10 zum Senden eines Sicherheitssignals über die Sicherheitssignalleitung 21 und die Antenne 11. Dieses Sicherheitssignal enthält eine pseudo-zufällige Bitfolge, die auch dem Auswertemittel 13 zur Verfügung gestellt wird. Das von der Antenne 11 abgestrahlte Sicherheitssignal wird von der Antenne 18 des Beeinflussungsmittels 17 empfangen und über die Sicherheitssignalleitung 26 an eine Hochfrequenzeinheit 19 weitergegeben. Die Hochfrequenzeinheit 19 erstellt aus dem Takt des Sicherheitssignals eine Versorgungsspannung für das Beeinflussungsmittel 17 und demoduliert das Sicherheitssignal, um die pseudo-zufällige Bitfolge zu extrahieren und über die Informationsleitung 27 zur Signalbeeinflussungssteuerung 20 zu übermitteln. Die Hochfrequenzeinheit 19 setzt außerdem mit dem erstmaligen Auftreten eines Sicherheitssignals an der Antenne 18 den Verzögerungszeitgeber 20A, um eine Verzögerungszeit zu starten.

Die Signalbeeinflussungssteuerung 20 wendet auf die Bitfolge des Sicherheitssignals einen für diese spezielle Chipkarte spezifischen Algorithmus an, um ein Beeinflussungssignal zu generieren. Das Auswertemittel 13 wendet auf die Bitfolge des Sicherheitssignals denselben spezifischen Algorithmus an und ermittelt somit ebenfalls das Beeinflussungssignal.

Die Signalbeeinflussungssteuerung 20 übermittelt über die Informationsleitung 27 das von Ihr ermittelte Beeinflussungssignal an die Hochfrequenzeinheit 19, die ihrerseits durch Lastmodulation den Rückstrahlquerschnitt der Antenne 18 mit dem Beeinflussungssignal moduliert. Mit Hilfe dieser Rückstrahlquerschnittsmodulation an der Antenne 18 kann ein in dem Detektionsmittel 12 enthaltener Empfänger/Demodulator über die Antenne 11 und die Sicherheitssignalleitung 21 das beeinflußte Sicherheitssignal erfassen und die Beeinflussungsinformation demodulieren. Die von dem Detektionsmittel 12 detektierte und extrahierte Information wird über die Verbindung 22 zum Auswertemittel 13 übermittelt, wo sie mit der im Auswertemittel 13 ermittelten Information verglichen wird. Liegen von dem Auswertemittel 13 eventuell ermittelte Abweichungen zwischen der von dem Detektionsmittel 12 detektierten Beeinflussungsinformation und der im Auswertemittel ermittelten Beeinflussungsinformation innerhalb eines zulässigen Toleranzbereiches, gilt der diesbezügliche Teil des beeinflußten Sicherheitssignals als erkannt. Falls das Beeinflussungsmittel entfernt worden ist oder durch ein anderes gleichartiges Beeinflussungsmittel ersetzt worden ist, wird das Auswertemittel diese erwartete Beeinflussungsinformation nicht ermittel-n können.

Die Hochfrequenzschnittstelle 19 des Beeinflussungsmittels 17 beginnt mit der Lastmodulation erst, wenn der Verzögerungszeitgeber 20A nach Ablauf einer individuellen Verzögerungszeit ein entsprechendes Startsignal zur Hochfrequenzschnittstelle übermittelt. Vorzugsweise hängt die Zeitkonstante des Verzögerungszeitgebers 20A von der relativen Lage des Beeinflussungsmittels 17 zur Antenne 11 und/oder zu dem Chip 16 ab. Dadurch ist die relative Lage zwischen Beeinflussungsmittel 17 und Sicherheitseinrichtung 9 wesentlich für die Zeitspanne zwischen dem Empfangen eines Sicherheitssignals durch die Hochfrequenzschnittstelle 19 und dem Starten der Lastmodulation durch diese Hochfrequenzschnittstelle 19.

Im Auswertemittel 13 ist ein für diese spezielle Chipkarte spezifischer Verzögerungszeittoleranzbereich gespeichert, der vorzugsweise nach Fertigstellung der Chipkarte ermittelt worden ist. Das Auswertemittel 13 vergleicht die Zeitspanne zwischen dem Abgeben eines Sicherheitssignals über die Antenne 11 und dem Detektieren einer Beeinflussungsinformation durch das Detektionsmittel 12 mit diesem festgelegten Toleranzbereich. Liegt diese Zeitspanne innerhalb des genannten Toleranzbereiches, so gilt auch dieser Teil des beeinflußten Sicherheitssignals als erkannt. Falls das Beeinflussungsmittel 17 oder der Chip 16 entfernt worden ist, selbst wenn die Datenträgeranordnung nachträglich wieder zusammengesetzt worden ist, wird eine Änderung der durch die Anordnung von Beeinflussungsmittel 17 und Chip 16 bzw. Antenne 11 festgelegten Zeitkonstante auftreten. Somit wird das Auswertemittel diese erwartete Beeinflussungsinformation nicht ermittelten können.

Falls die Beeinflussungsinformation relativ zu der in dem Auswertemittel 13 ermittelten Information eine zu große Fehlerrate aufweist oder falls die Zeit zwischen dem Abgeben eines Sicherheitssignals und dem Empfangen einer Beeinflussungsinformation nicht innerhalb des vorgegebenen Toleranzbereiches liegt, gibt das Auswertemittel 13 an das Sperrmittel 14 eine Sperrinformation, um das Sperren der Übertragung sicherheitsrelevanter Daten aus dem EEPROM 5 in den Arbeitsspeicher 6 zu verhindern.

Darüber hinaus kann die Sperrinformation, die das Sperrmittel 14 zur Steuereinheit 3 übermittelt, auch ein Löschen des Arbeitsspeichers 6 veranlassen.

In einer besonders günstigen Ausgestaltungsform einer solchen tragbaren Datenträgeranordnung wird die Zeitkonstante des Verzögerungszeitgebers 20A erst gestartet, wenn eine bestimmte Startinformation, die von der Steuereinheit 3 gesendet wird, in der RF-Schnittstelle 19 ermittelt wird. Dadurch wird die Verzögerungszeit nicht mehr unmittelbar abhängig vom leicht zu ermittelnden Einschaltzeitpunkt des Beeinflussungsmittels 17.

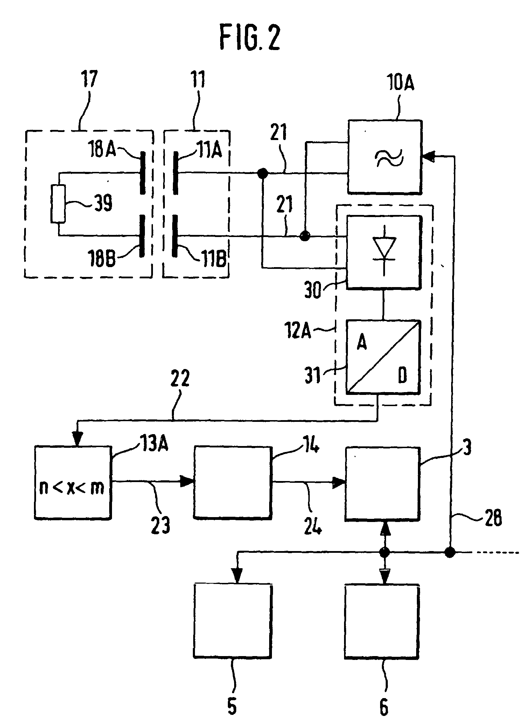

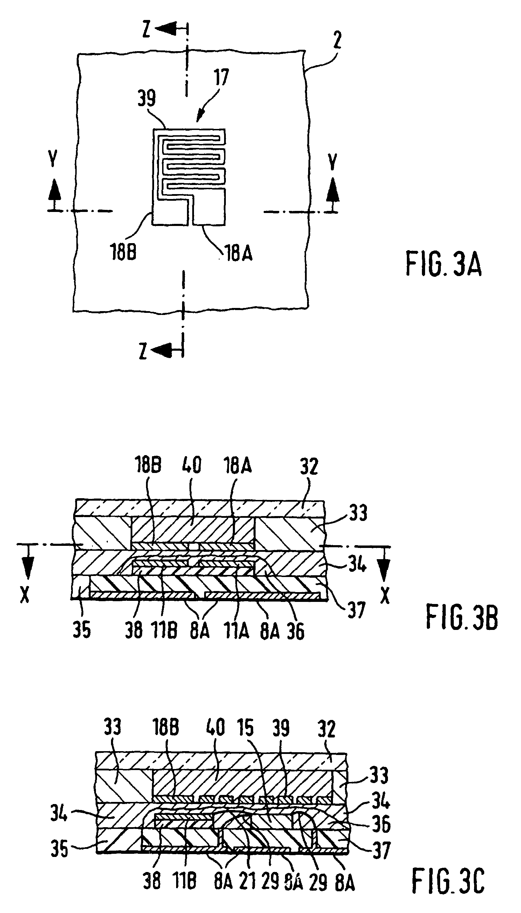

Das Ausführungsbeispiel gemäß Fig. 1 behandelt eine tragbare Datenträgeranordnung 1 mit relativ komplizierter Sicherheitseinrichtung 9 und entsprechend kompliziertem Beeinflussungsmittel 17, um einen hohen Sicherheitsstandard zu gewährleisten. Demgegenüber behandelt das Ausführungsbeispiel gemäß den Fig. 2 und 3 eine Datenträgeranordnung mit einfach zu realisierendem Beeinflussungsmittel 17 und einfach zu realisierender Sicherheitseinrichtung 9. Hierbei baut die Datenträgeranordnung gemäß den Fig. 2 und 3 auf einer Anordnung gemäß Fig. 1 auf, so daß in den Fig. 2 und 3 nur für die unterschiedliche Funktionsweise des Ausführungsbeispiels wesentliche Funktionseinheiten wiedergegeben sind.

Fig. 2 zeigt eine Steuereinheit 3 zum Steuern der Funktionsabläufe der Datenträgeranordnung, die über einen Daten- und Steuerbus 28 mit einem EEPROM-Speicher 5 und einem Arbeitsspeicher 6 sowie einem als Sendeeinheit zum Abgeben eines Sicherheitssignals vorgesehenen Oszillator 10A in Wirkverbindung steht. Zwei Ausgangsklemmen des Oszillators 10A sind über eine Sicherheitssignalleitung 21 an Eingangsklemmen eines Spannungsdetektors 30 angeschlossen sowie an je eine elektrisch leitende Fläche 11A und 11B, die gemeinsam die Koppeleinheit 11 der Sicherheitseinrichtung bilden. Die elektrisch leitende Fläche 11A bildet gemeinsam mit einer elektrisch leitenden Fläche 18A eines Beeinflussungsmittels 17 eine Kapazität. Auch die elektrisch leitende Fläche 11B bildet gemeinsam mit einer elektrisch leitenden Fläche 18B des Beeinflussungsmittels 17 eine Kapazität. Die elektrisch leitenden Flächen 18A und 18B des Beeinflussungsmittels 17 sind über eine Induktivität 39 miteinander verbunden, so daß der Oszillator 10A mit einem Serienschwingkreis aus der Serienschaltung der Kapazitäten 11A mit 18A, 11B mit 18B sowie der Induktivität 39 belastet ist. Die Ausgangsamplitude des Oszillators 10A hängt sehr stark von der Abweichung der Resonanzfrequenz des genannten Schwingkreises 11A, 18A, 11B 18B, 39 und der Oszillatorfequenz des Oszillators 10A ab. Der genannte Spannungsdetektor 30, bei dem es sich vorzugsweise um einen hochohmigen Effektivwertgleichrichter oder Spitzenwertgleichrichter handelt, bildet gemeinsam mit einem Analogdigitalwandler 31 ein Detektionsmittel 12A mit Digitalsignalausgang. Der Ausgang dieses Detektionsmittels 12A ist über die Verbindung 22 zum Übermitteln des detektierten, beeinflußten Sicherheitssignals mit einem als Auswertemittel vorgesehenen Fensterkomparator 13A verbunden. Dieser Fensterkomparator 13A vergleicht, ob das Ausgangssignal des Analogdigitalumsetzers 31 und somit die Schwingungsamplitude oder der Spannungsmittelwert am Ausgang des Oszillators 10A innerhalb eines vorgegebenen Toleranzbereiches liegt. Der Fensterkomparator 13A übermittelt das Vergleichsergebnis über eine Verbindung 23 an ein Sperrmittel 14, das über eine Verbindung 24 abhängig von dem Vergleichsergebnis eine Sperrinformation zur Steuereinheit 3 übermittelt. Der Toleranzbereich des Fensterkomparators 13A wird vorzugsweise nach Fertigstellung einer Datenträgeranordnung gemäß Fig. 2 unter Berücksichtigung zulässiger, durch externe Einwirkungen bedingter Abweichungen festgelegt.

Da die Kapazitätswerte des aus der Koppeleinheit 11 und dem Beeinflussungsmittel 17 gebildeten Schwingkreises stark von der relativen Lage der metallischen Flächen 11A und 18A bzw. 11B und 18B zueinander abhängt, führt eine Manipulation der Datenträgeranordnung, insbesondere das Zerstören des Beeinflussungsmittels 17 oder das Entfernen und Wiedereinsetzen des Beeinflussungsmittels 17 mit hoher Wahrscheinlichkeit zu einer starken Abweichung der Resonanzfequenz des den Oszillator 10A belastenden Resonanzkreises 11A, 18A, 11B 18B, 39. Dies hat aufgrund der starken Frequenzabhängigkeit der Impedanz eines Schwingkreises große Auswirkungen auf die Ausgangssignalamplitude des Oszillators 10A. Somit kann der als Auswertemittel vorgesehene Fensterkomparator 13A mit sehr hoher Wahrscheinlichkeit eine Manipulation an der Koppeleinheit 11 der Sicherheitseinrichtung oder an dem Beeinflussungsmittel 17 erfassen und abhängig hiervon das Sperrmittel 14 zum Abgeben eines Sperrsignals über die Verbindung 24 veranlassen.

Die Fig. 3A, 3B und 3C zeigen Schnittdarstellungen durch einen Kartenkörper 2 im Bereich der Sicherheitseinrichtung und des Beeinflussungsmittels. Insbesondere wird ein besonders günstiges Beeinflussungsmittel gezeigt. Fig. 3A zeigt einen Abschnitt eines Körpers 2, der Teil einer kontaktbehafteten Chipkarte ist. Insbesondere ist ein Schnitt entlang der in Fig. 3B gezeigten Linie x - x dargestellt. In Fig. 3A ist eine Induktivität 39 gezeigt, die zwischen zwei metallischen Flächen 18A und 18B angeordnet ist. Diese Induktivität kann, wie in Fig. 3B, in der Schnittdarstellung entlang der in Fig. 3A gezeigten Schnittlinie y - y erkennbar ist, als metallisierte Reflexionsfläche eines Hologramms 40 ausgebildet sein.

In den Fig. 3B und 3C ist jeweils ein Schnitt durch eine kontaktbehaftete Chipkarte entlang der in Fig. 3A gezeigten Schnittlinien y - y bzw. z - z gezeigt. Diese Chipkarte besteht aus einem Kartenkörper 2 mit einer obenliegend dargestellten äußeren, vorzugsweise transparenten Kartenschicht 32, einer innenliegenden, ein Hologramm-Modul 40 aufnehmenden Kartenschicht 33, einer hieran angrenzenden innenliegenden, den Chip eines Chipkartenmoduls aufnehmenden inneren Kartenschicht 34 und einer untenliegend dargestellten äußeren Kartenschicht 35. Die unten untenliegend dargestellte äußere Kartenschicht 35 nimmt eine Trägerfolie 37 eines Chipmoduls mit außenliegenden Kontakten 8A eines Kontaktfeldes auf. Das aus der Trägerfolie 37, dem außenliegenden Kontaktfeld 8A, einem Chip 15, einer Klebefolie 38, elektrisch leitenden Flächen 11A und 11B, einer Chipabdeckung 36 und Verbindungsdrähten 21 sowie 29 bestehende Chipmodul ist hierbei derart unterhalb des Hologramm-Moduls 40 angeordnet, daß die metallische Fläche 18B des Hologramm-Moduls in einem vorbestimmten Abstand und mit vorbestimmter Überlappung gegenüber der metallischen Fläche 11B des Chipmoduls angeordnet ist und dass die metallische Fläche 18A des Hologramm-Moduls entsprechend gegenüber der metallischen Fläche 11A des Chipmoduls angeordnet ist, um Kondensatoren zu realisieren.

Wenn bei einer derartigen Konstellation von Chipmodul und Beeinflussungsmittel 17 das Chipmodul oder die metallische Fläche des Hologramms 40 aus der Karte gelöst wird, liegt am Ausgang des in Fig. 2 dargestellten Oszillators 10A kein Resonanzkreis an. Dementsprechend ist die Ausgangsamplitude des Oszillators 10A verglichen mit der Ausgangsamplitude des Oszillators bei Belastung mit einem auf die Oszillatorfequenz abgestimmten Schwingkreis sehr gering. Der Fensterkomparator 13A in Fig. 2 kann dementsprechend das Fehlen eines solchen Resonanzkreises leicht feststellen.

Selbst wenn die Metallisierungsschicht 18A, 18B, 39 des Hologramm-Moduls 40 oder das Chipmodul nachträglich wieder eingebaut werden, stimmen mit hoher Wahrscheinlichkeit der Überlappungsgrad der Kondensatorelektroden 11A und 18A bzw. 11B und 18B nicht mehr mit dem ursprünglichen Überlappungsgrad überein. Außerdem ist mit hoher Wahrscheinlichkeit der Abstand zwischen diesen genannten Kondensatorelektroden nicht identisch mit dem ursprünglichen Abstand. Dadurch bedingt ist die Resonanzfrequenz des durch nachträgliches Zusammenbauen der einzelnen Komponenten der Datenträgeranordnung gebildeten Resonanzkreises nicht identisch mit der Resonanzfrequenz der ursprünglichen Anordnung. Auch solche Manipulationen einer erfindungsgemäßen Datenträgeranordnung 1 werden dementsprechend von dem Fensterkomparator 13A erkannt, und das Sperrmittel 14 kann ein Sperren einer sicherheitsrelevanten Funktion durch die Steuereinheit 3 veranlassen.

## Patentansprüche

1. Tragbare Datenträgeranordnung (1) mit einer Steuereinheit (3,15), einem der Datenträgeranordnung (1) seine äußere Form leihenden Körper (2), einem Mittel (7, 8) zum Ermöglichen eines Informationsaustauschs zwischen der Steuereinheit (3, 15) und einer externen Zugriffseinheit, und einem in einem Chip (16) integrierten Datenspeicher (4, 5, 6), in dem sicherheitsrelevante Daten speicherbar sind, einer Sicherheitseinrichtung (9) zum Senden eines Sicherheitssignals, durch ein im Körper (2) integriertes, mit der Sicherheitseinrichtung (9) verbundenes Beeinflussungsmittel (17) zum Beeinflussen des Sicherheitssignals, durch ein Detektionsmittel (11, 12) der genannten Sicherheitseinrichtung (9) zum Detektieren des vom Beeinflussungsmittel (17) beeinflußten Sicherheitssignals, durch ein Auswertemittel (13) zum Auswerten des detektierten, beeinflußten Sicherheitssignals und durch ein Sperrmittel (14) zum Sperren eines sicherheitskritischen Betriebszustandes der Datenträgeranordnung (1), falls das Auswertemittel (13) kein in erwarteter Weise beeinflußtes Sicherheitssignal erkennt, **dadurch gekennzeichnet, daß** die Sicherheitseinrichtung (9) nicht galvanisch mit den Beeinflussungsmittel (17) verbunden ist, das gesendete Sicherheitssignal als Information eine Bit-Folge enthält und das Beeinflussungsmittel (17) ausgelegt ist, um eine von dieser Bit-Folge in für das Auswertemittel (13) vorhersehbarer Weise abgeänderte Bit-Folge zu dem Detektionsmittel (11, 12) zu senden.

2. Datenträgeranordnung nach Anspruch 1 **dadurch gekennzeichnet, daß** das Detektionsmittel (12) und das Auswertemittel (13) zumindest teilweise im Chip (16) integriert sind, und dass als Auswertekriterium des Auswertemittels (13) eine beeinflußbare Komponente des Sicherheitssignals vorgesehen ist, die signifikant von der relativen Lage und/oder Entfernung des Beeinflussungsmittels (17) zu mindestens einer Komponente der Sicherheitseinrichtung (9) abhängt.

3. Datenträgeranordnung nach einem der vorhergehenden Ansprüche, **dadurch gekennzeichnet, daß** das Beeinflussungsmittel (17) eine im Hochfrequenzbereich wirksame passive elektrische Schaltung (18A, 18B, 39) ist, die eine frequenzabhängige Beeinflussung des Sicherheitssignals bewirkt.

4. Datenträgeranordnung nach einem der vorhergehenden Ansprüche, **dadurch gekennzeichnet, daß** das Beeinflussungsmittel (17) mindestens teilweise aus einer Metallschicht (18A, 18B, 39) im Körper besteht.

5. Datenträgeranordnung nach Anspruch 3 oder 4, **dadurch gekennzeichnet, daß** das Beeinflussungsmittel (17) ein Schwingkreis (18A, 18B, 39) ist.

6. Datenträgeranordnung nach einem der Ansprüche 1 - 2 **dadurch gekennzeichnet, daß** das Beeinflussungsmittel eine Transpondereinrichtung (18, 19, 20) ist.

7. Datenträgeranordnung nach einem der vorhergehenden Ansprüchen, **dadurch gekennzeichnet, daß** das Beeinflussungsmittel eine metallische Schicht (18A, 18B, 39) eines optisch wahrnehmbaren Sicherheitsmerkmals (40) nutzt.

8. Datenträgeranordnung nach einem der Ansprüche 5 - 7, **dadurch gekennzeichnet, daß** die Transpondereinrichtung (18, 19, 20) von der Sicherheitseinrichtung (9) mit Energie versorgt wird.

9. Dätenträgeranordnung nach einem der vorhergehenden Ansprüche, **dadurch gekennzeichnet, daß** das Auswertemittel (13) auf physikalische Eigenschaften des Beeinflussungsmittels (17) abgleichbar ist.

10. Datenträgeranordnung nach Anspruch 9, **dadurch gekennzeichnet, daß** das Sicherheitssignal ein Taktsignal zur Energieversorgung der Transpondereinrichtung (18, 19, 20) ist.

11. Datenträgeranordnung nach Anspruch 10, **dadurch gekennzeichnet, daß** die Transpondereinrichtung, nachdem sie von dem Sicherheitssignal mit Energie versorgt ist, eine gespeicherte Information abgibt.

12. Datenträgeranordnung nach einem der vorhergehenden Ansprüche, **dadurch gekennzeichnet, daß** die Sicherheitseinrichtung (9) und somit das von ihr gesendete Sicherheitssignal abgleichbar sind.

13. Datenträgeranordnung nach einem der vorhergehenden Ansprüche, **dadurch gekennzeichnet, daß** die Amplitude des detektierten, beeinflussten Sicherheitssignals als Auswertekriterium für das Auswertemittel (13) vorgesehen ist.

14. Datenträgeranordnung nach einem der vorhergehenden Ansprüche, **dadurch gekennzeichnet, daß** das Beeinflussungsmittel (17) unmittelbar benachbart zum Chip (16) im Körper (2) angeordnet ist.

## Claims

1. A portable data carrier system (1) having a control unit (3, 15), a body (2) giving the data carrier system (1) its external form, a means (7, 8) for permitting information exchange between the control unit (3, 15) and an external access unit, and a data memory (4, 5, 6) integrated in a chip (16), in which security-relevant data can be stored, a security device (9) for transmitting a security signal, an influencing means (17) integrated in the body (2) and connected with the security device (9) for influencing the security signal, a detection means (11, 12) of the stated security device (9) for detecting the security signal influenced by the influencing means (17), an evaluation means (13) for evaluating the detected, influenced security signal, and a blocking means (14) for blocking a security-critical operating state of the data carrier system (1) if the evaluation means (13) does not recognize a security signal influenced in the expected way, **characterized in that** the security device (9) is connected non-galvanically with the influencing means (17), the transmitted security signal contains a bit string as the information, and the influencing means (17) is designed to transmit a bit string altered from said bit string in a way predictable for the evaluation means (13) to the detection means (11, 12).

2. A data carrier system according to claim 1, **characterized in that** the detection means (12) and the evaluation means (13) are integrated at least partly in the chip (16), and the evaluation criterion of the evaluation means (13) is an influenceable component of the security signal that depends significantly on the position and/or distance of the influencing means (17) relative to at least one component of the security device (9).

3. A data carrier system according to either of the above claims, **characterized in that** the influencing means (17) is a passive electric circuit (18A, 18B, 39) effective in the radiofrequency range and causing frequency-dependent influencing of the security signal.

4. A data carrier system according to any of the above claims, **characterized in that** the influencing means (17) consists at least partly of a metal layer (18A, 18B, 39) in the body.

5. A data carrier system according to claim 3 or 4, **characterized in that** the influencing means (17) is a resonant circuit (18A, 18B, 39).

6. A data carrier system according to either of claims 1 - 2, **characterized in that** the influencing means is a transponder device (18, 19, 20).

7. A data carrier system according to any of the above claims, **characterized in that** the influencing means utilizes a metallic layer (18A, 18B, 39) of an optically perceptible security feature (40).

8. A data carrier system according to any of claims 5 - 7, **characterized in that** the transponder device (18, 19, 20) is supplied with energy by the security device (9).

9. A data carrier system according to any of the above claims, **characterized in that** the evaluation means (13) can be calibrated to physical properties of the influencing means (17).

10. A data carrier system according to claim 9, **characterized in that** the security signal is a clock signal for energy supply of the transponder device (18, 19, 20).

11. A data carrier system according to claim 10, **characterized in that** the transponder device delivers stored information after being supplied with energy by the security signal.

12. A data carrier system according to any of the above claims, **characterized in that** the security device (9) and thus the security signal transmitted thereby can be calibrated.

13. A data carrier system according to any of the above claims, **characterized in that** the amplitude of the detected, influenced security signal is provided as the evaluation criterion for the evaluation means (13).

14. A data carrier system according to any of the above claims, **characterized in that** the influencing means (17) is disposed immediately adjacent to the chip (16) in the body (2).

## Revendications

1. Support de données portable (1) doté d'une unité de commande (3, 15), d'un corps (2) donnant sa forme externe au support de données (1), de moyens (7, 8) pour permettre un échange d'informations entre l'unité de commande (3,15) et une unité d'accès externe, et d'une mémoire de données, (4, 5, 6) intégrée dans une puce (16), dans laquelle peuvent être enregistrées des données relatives à la sécurité, d'un dispositif de sécurité (9) destiné à envoyer un signal de sécurité, par le biais de moyens d'influence (17), intégrés dans le corps (2), reliés au dispositif de sécurité (9), destinés à influencer le signal de sécurité, par le biais de moyens de détection (11, 12) dudit dispositif de sécurité (9) destinés à détecter le signal de sécurité influencé par les moyens d'influence (17), par le biais de moyens d'évaluation (13) destinés à évaluer le signal de sécurité influencé et détecté et par le biais de moyens de blocage (14) destinés à bloquer un état de fonctionnement, critique pour la sécurité, du support de données (1) si les moyens d'évaluation (13) ne reconnaissent pas de signal de sécurité influencé de la façon attendue, **caractérisé en ce que** le dispositif de sécurité (9) n'est pas relié de manière galvanique aux moyens d'influence (17), **en ce que** le signal de sécurité émis en tant qu'information contient une série de bits et **en ce que** les moyens d'influence (17) sont conçus pour envoyer aux moyens de détection (11, 12) une série de bits modifiée, à partir de cette série de bits, d'une manière prévisible pour les moyens d'évaluation (13).

2. Support de données selon la revendication 1, **caractérisé en ce que** les moyens de détection (12) et les moyens d'évaluation (13) sont au moins partiellement intégrés dans la puce (16), et **en ce qu'**il est prévu comme critère d'évaluation des moyens d'évaluation (13), une composante influençable du signal de sécurité qui dépend de manière significative de la position et/ou de la distance relative des moyens d'influence (17) par rapport à au moins une composante du dispositif de sécurité (9).

3. Support de données selon l'une quelconque des revendications précédentes, **caractérisé en ce que** les moyens d'influence (17) sont un circuit électrique passif (18A, 18B, 39) opérant dans une plage de hautes fréquences, lequel circuit exerce une influence sur le signal de sécurité en fonction de la fréquence.

4. Support de données selon l'une quelconque des revendications précédentes, **caractérisé en ce que** les moyens d'influence (17) comportent au moins partiellement une couche métallique (18A, 18B, 39) dans le corps.

5. Support de données selon la revendication 3 ou 4, **caractérisé en ce que** les moyens d'influence (17) sont un circuit oscillant (18A, 18B, 39).

6. Support de données selon l'une quelconque des revendications 1 à 2, **caractérisé en ce que** les moyens d'influence sont un dispositif transpondeur (18, 19, 20).

7. Support de données selon l'une quelconque des revendications précédentes, **caractérisé en ce que** les moyens d'influence utilisent une couche métallique (18A, 18B, 39) d'une caractéristique de sécurité perceptible optiquement (40).

8. Support de données selon l'une quelconque des revendications 5 à 7, **caractérisé en ce que** le dispositif transpondeur (18, 19, 20) est alimenté en énergie par le dispositif de sécurité (9).

9. Support de données selon l'une quelconque des revendications précédentes, **caractérisé en ce que** les moyens d'évaluation (13) peuvent être ajustés aux propriétés physiques des moyens d'influence (17).

10. Support de données selon la revendication 9, **caractérisé en ce que** le signal de sécurité est un signal de synchronisation pour l'alimentation en énergie du dispositif transpondeur (18, 19, 20).

11. Support de données selon la revendication 10, **caractérisé en ce que** le dispositif transpondeur délivre une information enregistrée après qu'il a été alimenté en énergie par le signal de sécurité.

12. Support de données selon l'une quelconque des revendications précédentes, **caractérisé en ce que** le dispositif de sécurité (9) et ainsi le signal de sécurité qu'il délivre peuvent être ajustés.

13. Support de données selon l'une quelconque des revendications précédentes, **caractérisé en ce que** l'amplitude du signal de sécurité influencé, détecté, est prévue comme critère d'évaluation pour les moyens d'évaluation (13).

14. Support de données selon l'une quelconque des revendications précédentes, **caractérisé en ce que** les moyens d'influence (17) sont disposés à proximité immédiate de la puce (16) dans le corps (2).
